# EUROPÄISCHE PATENTANMELDUNG

(11) **EP 3 276 652 A2**
(43) Veröffentlichungstag der Anmeldung: **31.01.2018**
(21) Anmeldenummer: 17182111.9
(22) Anmeldetag: 23.03.2016
(51) Int. Cl.: H01L 21/58, H01L 21/60, H01L 23/373, H01L 23/495, H01L 23/498, H05K 3/32, H05K 3/34, H01L 21/683

(54) **VERFAHREN ZUM HERSTELLEN EINER SUBSTRATANORDNUNG MIT EINEM KLEBEVORFIXIERMITTEL, ENTSPRECHENDE SUBSTRATANORDNUNG, VERFAHREN ZUM VERBINDEN EINES ELEKTRONIKBAUTEILS MIT EINER SUBSTRATANORDNUNG MIT ANWENDUNG EINES AUF DEM ELEKTRONIKBAUTEIL UND/ODER DER SUBSTRATANORDNUNG AUFGEBRACHTEN KLEBEVORFIXIERMITTELS UND MIT EINER SUBSTRATANORDNUNG VERBUNDENES ELEKTRONIKBAUTEIL**

(30) Priorität: 02.04.2015 DE 102015105127; 18.05.2015 DE 102015107724
(62) Teilanmeldung aus: 16161902.8
(71) Anmelder: Heraeus Deutschland GmbH & Co. KG, 63450 Hanau (DE)
(72) Erfinder: Schäfer, Michael, 36093 Künzell (DE); Schmitt, Wolfgang, 63110 Rodgau (DE); Hinrich, Andreas, 63579 Freigericht (DE); Barrera-Marin, Isabel, 63450 Hanau (DE)
(74) Vertreter: Kilchert, Jochen

(57) **Zusammenfassung**

Die Erfindung betrifft ein Verfahren zum Herstellen einer Substratanordnung (10, 10') zur Verbindung mit einem Elektronikbauteil (50; 51), umfassend die Schritte:
- Bereitstellen eines Substrates (20), insbesondere eines DCB-Substrats, eines PCB-Substrats oder eines Leadframes, mit einer ersten Seite (22) und einer zweiten Seite (23),
- abschnittsweises Aufbringen eines Vorfixiermittels (30) auf die erste Seite (22) des Substrates (20),
wobei das Vorfixiermittel (30) ein Klebemittel ist, das 20 - 45 Gew.-% thermoplastisches Polymer, 40 - 70 Gew.-% organisches Lösemittel, 10 - 25 Gew.-% anorganische Füllstoffpartikel und 0 - 0,5 Gew.-% weitere Additive aufweist.

Die Erfindung betrifft auch eine entsprechende Substratanordnung (10, 10') sowie ein entsprechendes Verfahren zum Verbinden (Versintern, Verlöten, Verpressen) eines Elektronikbauteils (50, 51) mit der Substratanordnung (10, 10').

Durch die erfindungsgemäßen Maßnahmen wird beim Transport vom Ort des Bestückens der Substratanordnung (10, 10') mit dem Elektronikbauteil (50, 51') zum Ort des Verbindens eine ausreichende Transportfestigkeit erzeugt.

Das Vorfixiermittel (30) kann auch alternativ oder zusätzlich auf die erste Seite (52) des Elektronikbauteils (50, 51) abschnittsweise aufgebracht werden.

Auf die Substratanordnung (10, 10') und/oder auf das Elektronikbauteil (50, 51) kann vor dem Aufbringen des Vorfixiermittels (30) ein Kontaktierungsmaterial (25) aufgebracht werden. Das Vorfixiermittel (30) kann zumindest abschnittsweise seitlich des Kontaktierungsmaterials (25) aufgebracht werden, derart, dass das Vorfixiermittel (30) dicker als das Kontaktierungsmaterial (25) ist.

Das Vorfixiermittel (30) wird während des Verbindens oder nach dem Verbinden zumindest teilweise entfernt, insbesondere abgebrannt und/oder abgeschmolzen.

Nach dem Verbinden ist auf der ersten Seite (22) des Substrates (20) und/oder auf der dem Substrat (20) zugewandten ersten Seite (52) des Elektronikbauteils (50, 51) abschnittsweise ein Rest (31) des Vorfixiermittels (30), insbesondere die anorganischen Füllstoffpartikel, ausgebildet.

## Beschreibung

Die Erfindung bezieht sich auf ein Verfahren zum Herstellen einer Substratanordnung zur Verbindung mit einem Elektronikbauteil. Des Weiteren betrifft die Erfindung eine Substratanordnung zur Verbindung mit einem Elektronikbauteil. Außerdem betrifft die Erfindung ein Verfahren zum Verbinden eines Elektronikbauteils mit einer Substratanordnung. Des Weiteren betrifft die Erfindung ein Verfahren zum Verbinden eines Elektronikbauteils mit einem Substrat. Ferner betrifft die Erfindung ein Elektronikbauteil, dass mit einer Substratanordnung verbunden ist.

In der Leistungselektronik ist es bekannt, Substrate oder Bauteile mit getrockneter Sinterpaste bereitzustellen, die beispielsweise von einem Kunden nur noch appliziert werden müssen. Innerhalb des Fertigungsprozesses können Bauteile, insbesondere Elektronikbauteile, die an ein Substrat mit vorgetrockneter Sinterpaste angeheftet sind, beim Transport vom Ort des Bestückens zum Ort des Sinterns verrutschen.

Diesbezüglich ist es bekannt, dass die Bauteile, insbesondere Elektronikbauteile, auf die getrocknete Sinterpaste bei gleichzeitiger Wärmebeaufschlagung aufgesetzt werden. Es hat sich herausgestellt, dass ein derartiges warmes Bestücken bei einer Vielzahl von Elektronikbauteilen nur eine unzureichende Transportfestigkeit hervorruft, da die Adhäsion aufgrund gebogener Bauteile und/oder verschmutzter Oberflächen und/oder ungünstiger Oberflächen nicht ausreicht, um einen sicheren Transport vom Ort des Bestückens zum Ort des Sinterns zu ermöglichen. Daher ist es bekannt, die bestückten, aber noch nicht verlöteten bzw. versinterten Elektronikbauteile durch Masken oder Formen zu fixieren oder durch Federn aufwendig zu klemmen.

Ausgehend von diesem Stand der Technik ist es die Aufgabe der vorliegenden Erfindung ein Verfahren zum Herstellen einer Substratanordnung zur Verbindung mit einem Elektronikbauteil anzugeben, sodass beim Transport vom Ort des Bestückens zum Ort des Sinterns der Elektronikbauteile eine ausreichende Transportfestigkeit erzeugt wird.

Des Weiteren ist es Aufgabe der vorliegenden Erfindung eine Substratanordnung zur Verbindung mit einem Elektronikbauteil anzugeben, wobei die Substratanordnung derart ausgebildet ist, dass ein bestücktes, aber noch nicht verlötetes bzw. versintertes Bauteil auf der Substratanordnung eine ausreichende Transportfestigkeit aufweist.

Des Weiteren ist es eine Aufgabe der vorliegenden Erfindung ein Verfahren zum Verbinden eines Elektronikbauteils mit einer Substratanordnung anzugeben. Ferner ist es Aufgabe der Erfindung, ein Elektronikbauteil das mit einer Substratanordnung verbunden ist, anzugeben.

Erfindungsgemäß wird diese Aufgabe mit Blick auf das Verfahren zum Herstellen einer Substratanordnung zur Verbindung mit einem Elektronikbauteil durch den Gegenstand des Anspruchs 1, mit Blick auf die Substratanordnung durch den Gegenstand des Anspruchs 7, mit Blick auf das Verfahren zum Verbinden eines Elektronikbauteils mit einer Substratanordnung durch den Gegenstand des Anspruchs 11, mit Blick auf das Verfahren zum Verbinden eines Elektronikbauteils mit einem Substrat durch den Gegenstand des Anspruchs 13 und mit Blick auf das Elektronikbauteil durch den Gegenstand des Anspruchs 15 gelöst.

Die Erfindung beruht auf dem Gedanken, ein Verfahren zum Herstellen einer Substratanordnung zur Verbindung mit einem Elektronikbauteil anzugeben, das folgende Schritte umfasst:
- Bereitstellen eines Substrates, insbesondere eines DCB-Substrats oder eines PCB-Substrats oder eines Leadframes, mit einer ersten Seite und einer zweiten Seite,
- abschnittsweises Aufbringen eines Vorfixiermittels auf die erste Seite des Substrates.

Die mit Hilfe des erfindungsgemäßen Verfahrens hergestellte Substratanordnung dient zur nachfolgenden Verbindung mit einem Elektronikbauteil.

In einer bevorzugten Ausführungsform des erfindungsgemäßen Verfahrens wird auf die erste Seite des Substrates, insbesondere vor dem Aufbringen des Vorfixiermittels, abschnittsweise ein Kontaktierungsmaterial aufgebracht. Das Kontaktierungsmaterial bedeckt die erste Seite des Substrates nicht vollständig. Sowohl das Vorfixiermittel als auch das Kontaktierungsmaterial sind auf der ersten Seite des Substrates aufgebracht.

Das Kontaktierungsmaterial, das eine Sinterpaste, insbesondere eine silberhaltige Sinterpaste, oder ein Lot oder ein Leitkleber oder eine Klebefolie ist, dient zum tatsächlichen Verbinden des Substrates mit dem Elektronikbauteil. Das Vorfixiermittel dient lediglich zur Vorfixierung bzw. zu einem vorübergehenden Anheften des Substrates an dem Elektronikbauteil oder des Elektronikbauteils an dem Substrat. Aufgrund des Vorfixierens bzw. Anheftens wird eine ausreichende Transportfähigkeit des Bauteils vom Ort des Bestückens zum Ort des Sinterns hervorgerufen. Das Vorfixiermittel ist ein temporäres Fixiermittel. Mit anderen Worten ist das Vorfixiermittel ein Fixiermittel, das eine vorübergehende Fixierung einer Substratanordnung bzw. eines Substrates mit einem Elektronikbauteil ermöglicht.

Bei dem Vorfixiermittel kann es sich um ein Lot und/oder um ein Klebemittel handeln. Insbesondere ist das Vorfixiermittel ein Klebemittel, das 20 bis 45 Gew.-% thermoplastisches Polymer und 40 bis 70 Gew.-% organisches Lösemittel und 10 bis 25 Gew.-% anorganische Füllstoffpartikel und 0 bis 0,5 Gew.-% weitere Additive aufweist.

Das thermoplastische Polymer des Vorfixiermittels weist beispielsweise eine Glasübergangstemperatur von 60 bis 120 °C auf. Die Bestimmung der Glasübergangstemperatur wird mittels DDK, nämlich mittels dynamischer Differenzkalorimetrie, bzw. mittels DSC, nämlich differential scanning calorimetry, bei einer Aufheizrate von 10 K/Minute durchgeführt.
Bei dem thermoplastischen Polymer kann es sich insbesondere um (Meth)acrylcopolymere handeln. Der Molmassenbereich der thermoplastischen (Meth)acrylcopolymere kann 35.000 bis 70.000 g/mol betragen (Mw= 35.000 bis 70.000 g/mol). Der Molmassenbereich ist mittels Gelpermeationschromatographie (GPC) zu bestimmen. Für die Gelpermeationschromatographie gilt: Polystyrolgel als stationäre Phase, Tetrahydrofuran als mobile Phase, Polystyrolstandards.

Die 40 bis 70 Gew.-% organische Lösemittel weisen 30 bis 100 Gew.-% Terpineole auf.

Die 10 bis 25 Gew.-% anorganische Füllstoffpartikel weisen eine Teilchengröße (d50) von 5 bis 20 µm, bevorzugt von 5 bis 10 µm, auf. Bei diesen anorganischen Füllstoffpartikel kann es sich beispielsweise um Aluminiumoxid und/oder Siliziumdioxid handeln. Die Bestimmung der Teilchengröße (d50) erfolgt vorzugsweise mittels eines Laserbeugungsverfahrens.

Bei den 0 bis 0,5 Gew.-% weitere Additive kann es sich beispielsweise um Benetzungsmittel handeln.

Mit Hilfe eines Klebemittels, insbesondere mit Hilfe eines Klebemittels mit angegebener Zusammensetzung bzw. mit angegebener Formulierung, können gleichmäßige Vorfixiermittelpunkte, insbesondere Klebepunkte, mit kalkulierbarer Endhöhe erzeugt werden.

Das Vorfixiermittel kann durch Dispensen oder Dippen oder Jetten auf die erste Seite des Substrates aufgebracht werden. Insbesondere wird das Vorfixiermittel in Form von halbkugelförmigen Klebepunkten bzw. halbkugelförmigen Punkten aufgebracht.

Das Kontaktierungsmaterial kann eine Sinterpaste, insbesondere eine silberhaltige Sinterpaste, oder ein Lot oder ein Leitkleber oder eine Klebefolie sein.

Das auf das Substrat aufgebrachte Vorfixiermittel, insbesondere das auf das Substrat aufgebrachte Vorfixiermittel und das auf das Substrat aufgebrachte Kontaktierungsmaterial, kann getrocknet werden bzw. können getrocknet werden. Mit anderen Worten wird das Substrat mit dem aufgebrachten Vorfixiermittel und/oder dem aufgebrachten Kontaktierungsmaterial einem Trocknungsprozess ausgesetzt. Das Trocknen kann bei 100 bis 150 °C Objekttemperatur für 2 bis 30 Minuten durchgeführt werden.

Sofern ein Trocknen bzw. Vortrocknen durchgeführt wird, wird die Dicke des aufgebrachten Vorfixiermittels nach dem Trocknen bzw. Vortrocknen bzw. aufgrund des Trocknens bzw. Vortrocknens reduziert.

In einer weiteren Ausführungsform der Erfindung kann das Substrat mit aufgebrachtem Vorfixiermittel, insbesondere mit aufgebrachten Vorfixiermittel und aufgebrachtem Kontaktierungsmaterial, auf einem Träger derart positioniert werden, dass die erste Seite des Substrates dem Träger zugewandt angeordnet ist, wobei das Vorfixiermittel und/oder das Kontaktierungsmaterial mit dem Träger zumindest haftverbunden wird bzw. werden. Das Substrat kann folglich auf einem Träger aufgebracht werden, sodass die Substratanordnung, die ein Substrat, ein Vorfixiermittel, optional ein Kontaktierungsmaterial und optional einen Träger umfasst, zu einer weiteren Produktionsstätte bzw. zu einer weiteren Verarbeitungsvorrichtung transportiert werden kann. Es ist möglich, dass lediglich das Vorfixiermittel mit dem Träger haftverbunden ist. Zwischen dem Träger und einem optional vorhandenen Kontaktierungsmaterial kann beispielsweise ein geringer Abstand bestehen.

Das Vorfixiermittel ist zumindest abschnittsweise seitlich des Kontaktierungsmaterials auf die erste Seite des Substrates aufgebracht. Das Vorfixiermittel kann seitlich des Kontaktierungsmaterials mittels Dispensen, Dippen oder Jetten aufgebracht werden. Beispielsweise kann das Vorfixiermittel als mindestens ein Klebepunkt seitlich des Kontaktierungsmaterials aufgebracht werden. Des Weiteren ist es denkbar, dass das Vorfixiermittel balkenförmig seitlich des Kontaktierungsmaterials auf die erste Seite des Substrates aufgebracht wird. Ebenso ist es möglich, dass das Kontaktierungsmaterial vollseitenumfänglich von einem Vorfixiermittel umgeben ist.

Das Vorfixiermittel kann derart auf die erste Seite des Substrates aufgebracht werden, dass das Vorfixiermittel dicker als das Kontaktierungsmaterial ist. Mit anderen Worten steht das Vorfixiermittel in vertikaler Richtung über das Kontaktierungsmaterial über. Das Vorfixiermittel weist eine größere Materialdicke als das Kontaktierungsmaterial auf. Das Vorfixiermittel ist vor einem optionalen Trocknen bzw. Vortrocknen dicker als nach dem Trocknen bzw. Vortrocknen.

Die Erfindung beruht des Weiteren auf dem Gedanken, eine Substratanordnung zur Verbindung mit einem Elektronikbauteil anzugeben, wobei die Substratanordnung vorzugsweise mit einem vorerwähnten erfindungsgemäßen Verfahren hergestellt ist. Die erfindungsgemäße Substratanordnung umfasst ein Substrat mit einer ersten Seite und einer zweiten Seite, wobei auf der ersten Seite des Substrats abschnittsweise ein Vorfixiermittel aufgebracht ist.

Bei dem Substrat kann es sich um ein DCB-Substrat oder PCB-Substrat oder einen Leadframe handeln. Mit anderen Worten kann das Substrat ein DCB-Substrat oder ein PCB-Substrat oder ein Leadframe sein.

Das Vorfixiermittel kann ein Lot und/oder ein Klebemittel sein. Insbesondere handelt es sich bei dem Vorfixiermittel um ein Klebemittel, das 20 bis 45 Gew.-% thermoplastisches Polymer und 40 bis 70 Gew.-% organisches Lösemittel und 10 bis 25 Gew.-% anorganische Füllstoffpartikel und 0 bis 0,5 Gew.-% weitere Additive aufweist. Bezüglich des Klebemittels und der Zusammensetzung sowie hinsichtlich der Verfahren zur Bestimmung einzelner Parameter des Klebemittels wird auf die bereits angeführten Erläuterungen im Zusammenhang mit dem vorerwähnten Verfahren verwiesen. Diese Erläuterungen gelten auch für die Substratanordnung.

Auf der ersten Seite des Substrates ist vorzugsweise außerdem abschnittsweise ein Kontaktierungsmaterial aufgebracht. Auf der ersten Seite des Substrates kann somit sowohl ein Vorfixiermittel als auch ein Kontaktierungsmaterial aufgebracht sein. Das Vorfixiermittel dient in einem Verfahren zum Aufbringen eines Elektronikbauteils zu einer Vorfixierung des Elektronikbauteils auf der Substratanordnung. Das Kontaktierungsmaterial dient hingegen zur tatsächlichen Fixierung bzw. zum tatsächlichen und dauerhaften Verbinden der Substratanordnung mit dem Elektronikbauteil.

Das Kontaktierungsmaterial kann eine Sinterpaste, insbesondere eine silberhaltige Sinterpaste, oder ein Lot oder ein Leitkleber oder eine Klebefolie sein.

Das Vorfixiermittel ist zumindest abschnittsweise seitlich des Kontaktierungsmaterials auf der ersten Seite des Substrates aufgebracht. Das Vorfixiermittel kann tropfenförmig, halbkugelförmig oder balkenförmig seitlich des Kontaktierungsmaterials ausgebildet sein. In einer Ausführungsform der Erfindung ist es möglich, dass das Kontaktierungsmaterial voll seitenumfänglich von dem Vorfixiermittel umrandet bzw. umgeben ist.

Das Vorfixiermittel ist vorzugsweise dicker als das Kontaktierungsmaterial ausgebildet. Mit anderen Worten steht das Vorfixiermittel in vertikaler Richtung über das Kontaktierungsmaterial hinaus.

In einer weiteren Ausführungsform weist die Substratanordnung einen Träger auf, der mit dem Vorfixiermittel und/oder mit dem Kontaktierungsmaterial zumindest haftverbunden ist. Das Substrat ist in Relation zu dem Träger derart angeordnet, dass die erste Seite des Substrates dem Träger zugewandt angeordnet ist. Der Träger dient dazu, dass die Substratanordnung von einer ersten Produktionsstätte zu einer weiteren Produktionsstätte bzw. von einer ersten Fertigungsvorrichtung zu einer weiteren Fertigungsvorrichtung transportiert werden kann. Bei dem Träger kann es sich beispielsweise um eine Trägerfolie mit geringer Adhäsionskraft handeln.

Die Erfindung beruht des Weiteren auf dem Gedanken, ein Verfahren zum Verbinden eines Elektronikbauteils mit einer Substratanordnung anzugeben. Bei der Substratanordnung kann es sich insbesondere um eine erfindungsgemäße Substratanordnung und/oder um eine Substratanordnung, die mit Hilfe des beschriebenen erfindungsgemäßen Verfahrens hergestellt wurde, handeln. Das erfindungsgemäße Verfahren zum Verbinden eines Elektronikbauteils mit einer Substratanordnung umfasst die Schritte:
- Positionieren der Substratanordnung und des Elektronikbauteil zueinander derart, dass eine/die erste Seite des Substrates dem Elektronikbauteil zugewandt angeordnet ist,
- Vorfixieren der Substratanordnung auf dem Elektronikbauteil durch ein/das auf der ersten Seite des Substrates abschnittsweise aufgebrachte(s) Vorfixiermittel,
- Verbinden der Substratanordnung mit dem Elektronikbauteil.

Das Positionieren der Substratanordnung und des Elektronikbauteils zueinander derart, dass eine/die erste Seite des Substrates dem Elektronikbauteil zugewandt angeordnet ist, kann zum einen derart ausgeführt werden, dass die Substratanordnung auf das Elektronikbauteil aufgesetzt wird. In einer weiteren Ausführungsform ist es denkbar, dass das Elektronikbauteil auf der Substratanordnung aufgebracht wird.

Nach dem Positionieren der Substratanordnung und dem Elektronikbauteil zueinander wird ein Vorfixieren der Substratanordnung mit dem Elektronikbauteil vorgenommen. Dieses Vorfixieren wird mit Hilfe des auf der ersten Seite des Substrates abschnittsweise aufgebrachten Vorfixiermittels durchgeführt. Hierzu erfolgt vorzugsweise eine Wärmebeaufschlagung. Vorzugsweise wird eine Temperatur von 100 bis 150 °C aufgebracht, sodass das Vorfixiermittel über die aufgebrachte Wärme aktiviert wird und somit die Substratanordnung mit dem Elektronikbauteil vorfixiert werden kann. Aufgrund des Vorfixierens kann eine derartige Transportfestigkeit hinsichtlich des mit der Substratanordnung vorfixiert verbundenen Elektronikbauteils erzielt werden, dass das Elektronikbauteil nicht mehr aufgrund des Vorschubs eines Transportbandes losgeschüttelt werden kann. Vielmehr bleibt das Elektronikbauteil in der vorfixierten Lage.

Bei dem Elektronikbauteil kann es sich um einen Halbleiter oder ein DCB-Substrat oder ein PCB-Substrat handeln. Mit anderen Worten kann das Elektronikbauteil ein Halbleiter oder ein DCB-Substrat oder ein PCB-Substrat sein.

Zeitlich nach dem Vorfixieren erfolgt das Verbinden der Substratanordnung mit dem Elektronikbauteil. Das Verbinden der Substratanordnung mit dem Elektronikbauteil kann beispielsweise mittels Versintern oder Verpressen oder Verlöten erfolgen. Vorzugsweise wird die Substratanordnung mit dem Elektronikbauteil versintert. Hierzu weist die Substratanordnung ein Kontaktierungsmaterial, insbesondere eine Sinterpaste, auf.

Bezüglich des Vorfixiermittels im Zusammenhang mit dem erfindungsgemäßen Verfahren zum Verbinden eines Elektronikbauteils mit einer Substratanordnung wird auf die bereits aufgeführten Erläuterungen hinsichtlich des Vorfixiermittels verwiesen. Auch hinsichtlich der Anordnung des Vorfixiermittels und des Kontaktierungsmaterials zueinander wird auf die bereits aufgeführten Erläuterungen verwiesen.

Vorzugsweise wird die mit dem Elektronikbauteil fixierte Substratanordnung zum Verbinden der Substratanordnung mit dem Elektronikbauteil in einen Prozessofen transportiert. Bei dem Prozessofen kann es sich beispielsweise um einen Drucksinterofen oder einen Reflowofen oder einen Laminierofen handeln. Während des Sinterns oder während des Drucksinterns verflüchtigen sich die organischen und/oder polymeren Bestandteile des Vorfixiermittels weitestgehend. Die organischen und/oder polymeren Bestandteile des Vorfixiermittels werden verdampft und/oder thermisch zersetzt. Während des Verbindens der Substratanordnung mit dem Elektronikbauteil wird die Verbindung des Vorfixiermittels zum Elektronikbauteil entfernt, insbesondere abgebrannt und/oder abgeschmolzen.

Nach dem Verbinden der Substratanordnung mit dem Elektronikbauteil, insbesondere nach dem Versintern oder Drucksintern und/oder Verlöten und/oder Verspressen, sind auf der ersten Seite der Substratanordnung größtenteils oder ausschließlich die anorganischen Füllstoffe des Vorfixiermittels vorhanden. Es verbleiben somit größtenteils oder ausschließlich die anorganischen Füllstoffe des Vorfixiermittels. Bei dem beschriebenen Vorfixiermittel handelt es sich mit anderen Worten um ein temporäres Fixierungsmittel, das nach dem tatsächlichen Verbinden bzw. tatsächlich dauerhaften Verbinden der Substratanordnung mit dem Elektronikbauteil größtenteils oder vollständig entfernt ist.

Bei der Zusammensetzung des Vorfixiermittels wird vorzugsweise 20 bis 45 Gew.-% thermoplastisches Polymer mit einer derartigen Glasübergangstemperatur gewählt, sodass die Glasübergangstemperatur geringer ist als die Temperatur, die während des Vorfixierens auf die Substratanordnung wirkt, insbesondere geringer ist als die Wärmebeaufschlagung bei Temperaturen von 100 bis 150 °C.

Ein weiterer Aspekt der Erfindung beruht auf einem Verfahren zum Verbinden eines Elektronikbauteils mit einem Substrat, insbesondere mit einem DCB-Substrat oder einem PCB-Substrat oder einem Leadframe, wobei das Substrat eine erste Seite und eine zweite Seite aufweist und das Verfahren folgende Schritte umfasst:
- Bereitstellen eines Elektronikbauteils mit einer ersten Seite und einer zweiten Seite,
- abschnittsweises Aufbringen eines Vorfixiermittels auf die erste Seite des Elektronikbauteils und/oder auf die erste Seite des Substrats.

Es ist möglich, dass auf die erste Seite des Substrates und/oder auf die erste Seite des Elektronikbauteils, insbesondere vor dem Aufbringen des Vorfixiermittels, abschnittsweise ein Kontaktierungsmaterial aufgebracht wird. Das Kontaktierungsmaterial bedeckt die erste Seite des Substrates und/oder die erste Seite des Elektronikbauteils nicht vollständig. Sowohl das Vorfixiermittel als auch das Kontaktierungsmaterial können auf der ersten Seite des Kontaktierungsmaterials aufgebracht sein.

Das Kontaktierungsmaterial, das eine Sinterpaste, insbesondere eine silberhaltige Sinterpaste, oder ein Lot oder ein Leitkleber oder eine Klebefolie ist, dient zum tatsächlichen Verbinden des Substrates mit dem Elektronikbauteil. Das Vorfixiermittel dient lediglich zur Vorfixierung bzw. zu einem vorübergehenden Anheften des Substrates an dem Elektronikbauteil oder des Elektronikbauteils an dem Substrat. Aufgrund des Vorfixierens bzw. Anheftens wird eine ausreichende Transportfähigkeit des Bauteils vom Ort des Bestückens zum Ort des Sinterns hervorgerufen. Das Vorfixiermittel ist ein temporäres Fixiermittel. Mit anderen Worten ist das Vorfixiermittel ein Fixiermittel, das eine vorübergehende Fixierung eines Substrates mit einem Elektronikbauteil ermöglicht.

Bei dem Vorfixiermittel kann es sich um ein Lot und/oder um ein Klebemittel handeln. Insbesondere ist das Vorfixiermittel ein Klebemittel, das 20 bis 45 Gew.-% thermoplastisches Polymer und 40 bis 70 Gew.-% organisches Lösemittel und 10 bis 25 Gew.-% anorganische Füllstoffpartikel und 0 bis 0,5 Gew.-% weitere Additive aufweist.

Das thermoplastische Polymer des Vorfixiermittels weist beispielsweise eine Glasübergangstemperatur von 60 bis 120 °C auf. Die Bestimmung der Glasübergangstemperatur wird mittels DDK, nämlich mittels dynamischer Differenzkalorimetrie, bzw. mittels DSC, nämlich differential scanning calorimetry, bei einer Aufheizrate von 10 K/Minute durchgeführt.
Bei dem thermoplastischen Polymer kann es sich insbesondere um (Meth)acrylcopolymere handeln. Der Molmassenbereich der thermoplastischen (Meth)acrylcopolymere kann 35.000 bis 70.000 g/mol betragen (Mw= 35.000 bis 70.000 g/mol). Der Molmassenbereich ist mittels Gelpermeationschromatographie (GPC) zu bestimmen. Für die Gelpermeationschromatographie gilt: Polystyrolgel als stationäre Phase, Tetrahydrofuran als mobile Phase, Polystyrolstandards.

Die 40 bis 70 Gew.-% organische Lösemittel weisen 30 bis 100 Gew.-% Terpineole auf.

Die 10 bis 25 Gew.-% anorganische Füllstoffpartikel weisen eine Teilchengröße (d50) von 5 bis 20 µm, bevorzugt von 5 bis 10 µm, auf. Bei diesen anorganischen Füllstoffpartikeln kann es sich beispielsweise um Aluminiumoxid und/oder Siliziumdioxid handeln. Die Bestimmung der Teilchengröße (d50) erfolgt vorzugsweise mittels eines Laserbeugungsverfahrens.

Bei den 0 bis 0,5 Gew.-% weitere Additive kann es sich beispielsweise um Benetzungsmittel handeln.

Mit Hilfe eines Klebemittels, insbesondere mit Hilfe eines Klebemittels mit angegebener Zusammensetzung bzw. mit angegebener Formulierung, können gleichmäßige Vorfixiermittelpunkte, insbesondere Klebepunkte, mit kalkulierbarer Endhöhe erzeugt werden.

Das Vorfixiermittel kann durch Dispensen oder Dippen oder Jetten auf die erste Seite des Elektronikbauteils und/oder auf die erste Seite des Substrats aufgebracht werden. Insbesondere wird das Vorfixiermittel in Form von halbkugelförmigen Klebepunkten bzw. halbkugelförmigen Punkten aufgebracht.

Das aufgebrachte Vorfixiermittel, insbesondere das aufgebrachte Vorfixiermittel und das aufgebrachte Kontaktierungsmaterial, kann getrocknet werden bzw. können getrocknet werden. Mit anderen Worten wird das Elektronikbauteil und/oder das Substrat mit dem aufgebrachten Vorfixiermittel und/oder dem aufgebrachten Kontaktierungsmaterial einem Trocknungsprozess ausgesetzt. Das Trocknen kann bei 100 bis 150 °C Objekttemperatur für 2 bis 30 Minuten durchgeführt werden.

Sofern ein Trocknen bzw. Vortrocknen durchgeführt wird, wird die Dicke des aufgebrachten Vorfixiermittels nach dem Trocknen bzw. Vortrocknen bzw. aufgrund des Trocknens bzw. Vortrocknens reduziert.

Das Vorfixiermittel kann zumindest abschnittsweise seitlich eines Kontaktierungsmaterials auf die erste Seite des Elektronikbauteils und/oder auf die erste Seite des Substrats aufgebracht sein. Das Vorfixiermittel kann seitlich des Kontaktierungsmaterials mittels Dispensen, Dippen oder Jetten aufgebracht werden. Beispielsweise kann das Vorfixiermittel als mindestens ein Klebepunkt seitlich des Kontaktierungsmaterials aufgebracht werden. Des Weiteren ist es denkbar, dass das Vorfixiermittel balkenförmig seitlich des Kontaktierungsmaterials auf die erste Seite des Substrates aufgebracht wird. Ebenso ist es möglich, dass das Kontaktierungsmaterial vollseitenumfänglich von einem Vorfixiermittel umgeben ist.

Das Vorfixiermittel kann derart auf die erste Seite des Elektronikbauteils und/oder des Substrats aufgebracht werden, dass das Vorfixiermittel dicker als das Kontaktierungsmaterial ist. Mit anderen Worten steht das Vorfixiermittel in vertikaler Richtung über das Kontaktierungsmaterial über. Das Vorfixiermittel weist eine größere Materialdicke als das Kontaktierungsmaterial auf. Das Vorfixiermittel ist vor einem optionalen Trocknen bzw. Vortrocknen dicker als nach dem Trocknen bzw. Vortrocknen.

In einer weiteren Ausführungsform der Erfindung können das Elektronikbauteil mit aufgebrachtem Vorfixiermittel, insbesondere mit aufgebrachten Vorfixiermittel und/oder aufgebrachtem Kontaktierungsmaterial, auf einem Träger derart positioniert werden, dass die erste Seite des Elektronikbauteils dem Träger zugewandt angeordnet ist, wobei das Vorfixiermittel und/oder das Kontaktierungsmaterial mit dem Träger zumindest haftverbunden wird bzw. werden. Das Elektronikbauteil kann folglich auf einem Träger aufgebracht werden, sodass diese Anordnung zu einer weiteren Produktionsstätte bzw. zu einer weiteren Verarbeitungsvorrichtung transportiert werden kann. Es ist möglich, dass lediglich das Vorfixiermittel mit dem Träger haftverbunden ist. Zwischen dem Träger und einem optional vorhandenen Kontaktierungsmaterial kann beispielsweise ein geringer Abstand bestehen.

Das Verfahren zum Verbinden eines Elektronikbauteils kann außerdem folgende Schritte umfassen:
- Positionieren des Elektronikbauteils und des Substrates zueinander derart, dass die erste Seite des Elektronikbauteils dem Substrat zugewandt angeordnet ist,
- Vorfixieren des Elektronikbauteil mit dem Substrat durch das abschnittsweise aufgebrachte Vorfixiermittel,
- Verbinden des Elektronikbauteils mit dem Substrat.

Das Positionieren des Elektronikbauteils und des Substrates zueinander kann zum einen derart ausgeführt werden, dass das Substrat auf das Elektronikbauteil aufgesetzt wird. In einer weiteren Ausführungsform ist es denkbar, dass das Elektronikbauteil auf das Substrat aufgebracht wird.

Nach dem Positionieren des Substrates und des Elektronikbauteils zueinander wird ein Vorfixieren des Elektronikbauteils mit dem Substrat vorgenommen. Dieses Vorfixieren wird mit Hilfe des abschnittsweise aufgebrachten Vorfixiermittels durchgeführt. Hierzu erfolgt vorzugsweise eine Wärmebeaufschlagung. Mit anderen Worten kann beim Vorfixieren des Elektronikbauteils mit dem Substrat eine Wärmebeaufschlagung erfolgen. Vorzugsweise wird eine Temperatur von 100 bis 150 °C aufgebracht, sodass das Vorfixiermittel über die aufgebrachte Wärme aktiviert wird und somit das Elektronikbauteil mit dem Substrat vorfixiert werden kann.

Aufgrund des Vorfixierens kann eine derartige Transportfestigkeit hinsichtlich des mit dem Substrat vorfixiert verbundenen Elektronikbauteils erzielt werden, dass das Elektronikbauteil und/oder das Substrat nicht mehr aufgrund des Vorschubs eines Transportbandes losgeschüttelt werden kann. Vielmehr bleibt bzw. bleiben das Elektronikbauteil und/oder das Substrat in der vorfixierten Lage.

Bei dem Elektronikbauteil kann es sich um einen Halbleiter oder ein DCB-Substrat oder ein PCB-Substrat handeln. Zeitlich nach dem Vorfixieren erfolgt das Verbinden des Elektronikbauteils mit dem Substrat. Das Verbinden des Substrats mit dem Elektronikbauteil kann beispielsweise mittels Versintern oder Verpressen oder Verlöten erfolgen. Mit anderen Worten kann das Elektronikbauteil beim Verbinden mit dem Substrat mit diesem versintert oder verpresst oder verlötet werden. Vorzugsweise wird das Substrat mit dem Elektronikbauteil versintert. Hierzu weist bzw. weisen das Substrat und/oder das Elektronikbauteil ein Kontaktierungsmaterial, insbesondere eine Sinterpaste, auf.

Bezüglich des Vorfixiermittels im Zusammenhang mit dem erfindungsgemäßen Verfahren zum Verbinden eines Elektronikbauteils mit einem Substrat wird auf die bereits aufgeführten Erläuterungen hinsichtlich des Vorfixiermittels verwiesen.

Vorzugsweise wird das mit dem Elektronikbauteil fixierte Substrat zum Verbinden des Elektronikbauteils mit dem Substrat in einen Prozessofen transportiert. Bei dem Prozessofen kann es sich beispielsweise um einen Drucksinterofen oder einen Reflowofen oder einen Laminierofen handeln. Während des Sinterns oder während des Drucksinterns verflüchtigen sich die organischen und/oder polymeren Bestandteile des Vorfixiermittels weitestgehend. Die organischen und/oder polymeren Bestandteile des Vorfixiermittels werden verdampft und/oder thermisch zersetzt. Während des Verbindens des Elektronikbauteils mit dem Substrat wird die Verbindung des Vorfixiermittels entfernt, insbesondere abgebrannt und/oder abgeschmolzen.

Nach dem Verbinden des Elektronikbauteils mit dem Substrat, insbesondere nach dem Versintern und/oder Drucksintern und/oder Verlöten und/oder Verpressen, sind auf der ersten Seite der Substrats oder auf der ersten Seite des Elektronikbauteils größtenteils oder ausschließlich die anorganischen Füllstoffe des Vorfixiermittels vorhanden. Es verbleiben somit größtenteils oder ausschließlich die anorganischen Füllstoffe des Vorfixiermittels. Bei dem beschriebenen Vorfixiermittel handelt es sich mit anderen Worten um ein temporäres Fixierungsmittel, das nach dem tatsächlichen Verbinden bzw. tatsächlich dauerhaften Verbinden des Elektronikbauteils mit dem Substrat größtenteils oder vollständig entfernt ist. Mit anderen Worten wird das Vorfixiermittel während des Verbindens oder nach dem Verbinden, insbesondere während des Versinterns und/oder des Verlötens und/oder des Verpressens, des Substrates mit dem Elektronikbauteil zumindest teilweise entfernt, insbesondere abgebrannt und/oder abgeschmolzen.

Bei der Zusammensetzung des Vorfixiermittels wird vorzugsweise 20 bis 45 Gew.-% thermoplastisches Polymer mit einer derartigen Glasübergangstemperatur gewählt, sodass die Glasübergangstemperatur geringer ist als die Temperatur, die während des Vorfixierens wirkt, insbesondere geringer ist als die Wärmebeaufschlagung bei Temperaturen von 100 bis 150 °C.

Die Erfindung beruht des Weiteren auf dem Gedanken, ein Elektronikbauteil, das mit einer Substratanordnung oder einem Substrat verbunden ist, anzugeben. Bei der Substratanordnung kann es sich um eine erfindungsgemäße Substratanordnung handeln bzw. um eine derartige Substratanordnung, die mit Hilfe eines erfindungsgemäßen Verfahrens hergestellt ist. Insbesondere ist das Elektronikbauteil mit Hilfe eines erfindungsgemäßen Verfahrens mit der Substratanordnung verbunden. Alternativ ist das Elektronikbauteil mit einem Substrat nach einem erfindungsgemäßen Verfahren verbunden worden.

Das Substrat, insbesondere das Substrat einer Substratanordung, umfasst eine erste Seite und eine zweite Seite, wobei auf der ersten Seite des Substrates und/oder auf der dem Substrat zugewandten ersten Seite des Eleketronikbauteils abschnittsweise ein Rest eines Vorfixiermittel ausgebildet ist, wobei die Substratanordnung oder das Substrat mit dem Elektronikbauteil derart verbunden ist, dass die erste Seite des Substrates dem Elektronikbauteil zugewandt angeordnet ist. Auf der ersten Seite des Substrates kann des Weiteren abschnittsweise ein Kontaktierungsmaterial aufgebracht sein.

Das Substrat kann ein DCB-Substrat oder ein PCB-Substrat oder ein Leadframe sein. Das Elektronikbauteil kann ein Halbleiter oder ein DCB-Substrat oder ein PCB-Substrat sein. Der Rest des Vorfixiermittels kann ein Lot und/oder der Rest eines Klebemittels sein. Bei dem Klebemittel kann es sich um ein ursprüngliches thermoplastisches (Meth)acrylcopolymer handeln, wobei größtenteils, insbesondere ausschließlich, die anorganischen Füllstoffpartikel, insbesondere Aluminiumoxid und/oder Siliziumdioxid, auf der ersten Seite des Substrates und/oder auf der dem Substrat zugewandten Seite des Elektronikbauteils ausgebildet sind. Mit anderen Worten kann der Rest des Vorfixiermittels ein Lot und/oder der Rest eines Klebemittels, insbesondere eine Menge von anorganischen Füllstoffpartikeln, sein.

Die Erfindung wird nachfolgend mit weiteren Einzelheiten unter Bezugnahme auf die beigefügten schematischen Zeichnungen anhand von Ausführungsbeispielen näher erläutert. In diesen zeigen:
- Fig. 1 - 4:: einzelne Schritte des Verfahrens zum Herstellen einer Substratanordnung;
- Fig. 5 - 6:: weitere optionale Schritte zum Herstellen einer Substratanordnung;
- Fig. 7 - 9:: einzelne Schritte eines erfindungsgemäßen Verfahrens zum Verbinden eines Elektronikbauteils mit einer Substratanordnung gemäß einer ersten Ausführungsform; und
- Fig. 10 - 12:: einzelne Schritte eines erfindungsgemäßen Verfahrens zum Verbinden eines Elektronikbauteils mit einer Substratanordnung gemäß einer weiteren Ausführungsform.

Im Folgenden werden für gleiche und gleichwirkende Teile gleiche Bezugsziffern verwendet.

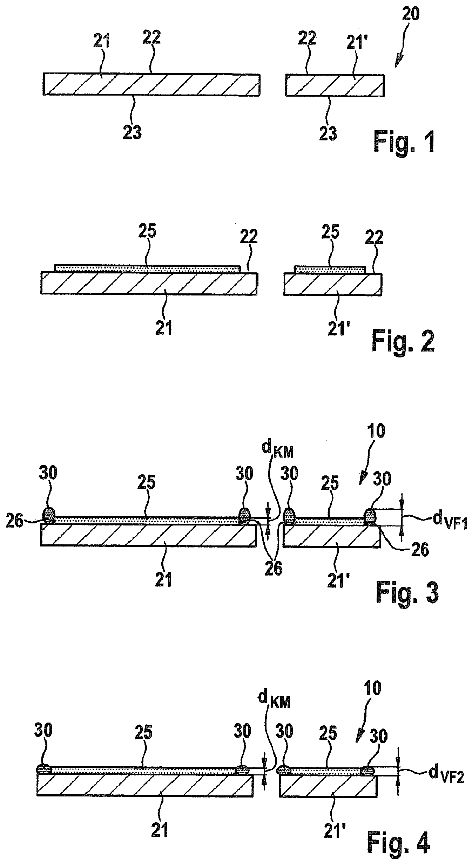

In Fig. 1 ist ein Substrat 20 dargestellt. Das Substrat 20 liegt strukturiert vor, d. h. dass einzelne Substratabschnitte 21, 21' gebildet sind. Bei dem Substrat kann es sich beispielsweise um einen Leadframe, ein DCB-Substrat oder ein PCB-Substrat handeln. Des Weiteren kann es vorgesehen sein, dass das Substrat 20 auf einer oder auf beiden Seiten beschichtet ist. Bei der Beschichtung kann es sich beispielsweise um eine Metallbeschichtung oder um eine Metalllegierungsbeschichtung handeln. Das Substrat 20 weist eine erste Seite 22 sowie eine zweite Seite 23 auf. Die erste Seite 22 des Substrates 20 ist im dargestellten Beispiel parallel zur gegenüberliegenden zweiten Seite 23 des Substrates 20 ausgebildet.

In Fig. 2 ist dargestellt, dass auf die erste Seite 22 des Substrates 20 ein Kontaktierungsmaterial 25 aufgebracht wird. Bei dem Kontaktierungsmaterial 25 kann es sich um ein Lot oder einen Leitkleber oder eine Klebefolie handeln. Insbesondere handelt es sich bei dem Kontaktierungsmaterial 25 um eine Sinterpaste. Vorzugsweise enthält die Sinterpaste Silber oder eine Silberlegierung. Das Kontaktierungsmaterial 25 kann auf die erste Seite 22 des Substrates 20 durch Drucken, insbesondere Siebdrucken und/oder Schablonendrucken, und/oder Rakeln und/oder Sprayen und/oder Jetten und/oder Dispensen aufgebracht werden.

Das Kontaktierungsmaterial 25 dient im Rahmen der herzustellenden Substratanordnung 10 zur Verbindung mit einem Elektronikbauteil 50, 51. Insbesondere dient das Kontaktierungsmaterial 25 zur dauerhaften Verbindung einer Substratanordnung 10 mit einem Elektronikbauteil 50, 51.

In Fig. 3 ist dargestellt, dass seitlich des Kontaktierungsmaterials 25 auf die erste Seite 22 des Substrats 20 ein Vorfixiermittel 30 aufgebracht ist. Das Vorfixiermittel 30 ist auf die erste Seite 22 des Substrates 20 tropfenförmig aufgebracht. Im dargestellten Beispiel sind vier tropfenförmige Vorfixiermittel 30 aufgebracht. Das Vorfixiermittel 30 ist sowohl auf dem linken Substratabschnitt 21 als auch auf dem rechten Substratabschnitt 21' aufgebracht. Das Vorfixiermittel 30 ist neben den Seitenkanten 26 des Kontaktierungsmaterials 25 auf der ersten Seite 22 des Substrates 20 aufgebracht. Zwischen dem Vorfixiermittel 30 und der Seitenkante 26 des Kontaktierungsmaterials 25 kann ein Abstand ausgebildet sein. Des Weiteren ist es denkbar, dass das Vorfixiermittel 30 balkenartig aufgebracht wird. Außerdem ist es möglich, dass das Kontaktierungsmaterials 25 vollumfänglich von einem Vorfixiermittel 30 umrandet ist. Auch in diesem Zusammenhang ist es denkbar, dass bei einer vollumfänglichen Umrandung des Kontaktierungsmaterials 25 mit einem Vorfixiermittel 30 ein Abstand zwischen dem Vorfixiermittel 30 und dem Kontaktierungsmaterial 25 ausgebildet ist. Das Vorfixiermittel 30 weist vorzugsweise folgende Zusammensetzung auf:
- 20 bis 45 Gew.-% thermoplastisches Polymer, insbesondere thermoplastisches (Meth)acrylcopolymer mit einer Glasübergangstemperatur von beispielsweise 60 °C bis 120 °C.
- 40 bis 70 Gew.-% organisches Lösemittel, wobei dieses organische Lösungsmittel vorzugsweise 30 bis 100 Gew.-% Terpineole aufweist.
- 10 bis 25 Gew.-% anorganische Füllstoffpartikel mit einer Teilchengröße (d50) von 5 bis 20 µm, insbesondere von 5 bis 10 µm. Vorzugsweise handelt es sich bei den anorganischen Füllstoffpartikeln um Aluminiumoxid und/oder Siliziumdioxid.
- 0 bis 0,5 Gew.-% weitere Additive, z. B. Benetzungsmittel.

Das Vorfixiermittel 30 kann durch Dispensen, Dippen oder Jetten auf die erste Seite 22 des Substrates 20 aufgebracht werden. Vorzugsweise ist das Vorfixiermittel 30 in Form halbkugelförmiger Klebepunkte auf die erste Seite 22 des Substrates 20 aufgebracht. Die Dicke d_{VF1} des Vorfixiermittels 30 weist einen größeren Wert als die Dicke d_{KM} des Kontaktierungsmaterials 25 auf. Mit anderen Worten ist die Dicke d_{VF1} des Vorfixiermittels 30 größer als die Dicke d_{KM} des Kontaktierungsmaterials 25. In Fig. 3 liegt das Vorfixiermittel 30 in einem ungetrockneten bzw. nicht getrockneten Zustand vor.

In Fig. 4 ist die Substratanordnung 10, die in diesem Verfahrenszustand das Substrat 20, das Vorfixiermittel 30 sowie das Kontaktierungsmittel 25 umfasst, in einem vorgetrockneten Zustand dargestellt. Die Trocknung des Vorfixiermittels 30 und des Kontaktierungsmaterials 25 findet vorzugsweise bei 100 bis 150 °C Objekttemperatur für 2 bis 30 Minuten statt. Nach dem Vortrocknen bzw. Trocknen ist die Dicke d_{VF1} des Vorfixiermittels 30 geringer als die Dicke d_{VF1} des Vorfixiermittels 30 vor dem Trocknen. Die Dicke d_{VF1} nimmt folglich im Zuge des Trocknungsprozesses ab. Die Dicke d_{VF2} ist allerdings auch nach dem Trocknen vorzugsweise größer als die Dicke d_{KM} des Kontaktierungsmaterials 25.

Eine Substratanordnung 10, wie diese in Fig. 4 dargestellt ist, ist ein Zwischenprodukt, das beispielsweise von einer ersten Fertigungsmaschine zu einer weiteren Fertigungsmaschine transportiert werden kann. Des Weiteren ist es denkbar, dass dieses Zwischenprodukt zu einer weiteren Produktionsstätte bzw. zu einem Kunden transportiert werden kann.

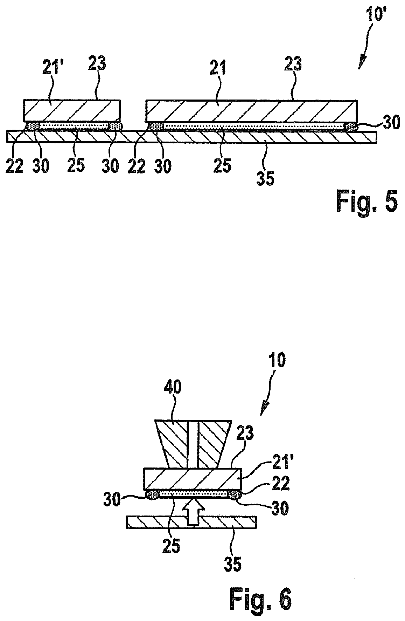

Gemäß Fig. 5 kann es optional vorgesehen sein, dass die Substratanordnung 10 einen Träger 35 umfasst. Bei dem Träger 35 kann es sich beispielsweise um ein Transferelement, insbesondere eine Transferfolie, handeln. Das Substrat 20 ist mit dem aufgebrachten Vorfixiermittel 30 und dem aufgebrachten Kontaktierungsmaterial 25 derart zum Träger 35 angeordnet, dass die erste Seite 22 des Substrates 20 dem Träger 35 zugewandt angeordnet ist. Mit anderen Worten weist die erste Seite 22 des Substrates 20 zum Träger 35. Im dargestellten Beispiel ist zumindest das Vorfixiermittel 30 mit dem Träger 35 haftverbunden. Es ist auch möglich, dass das Kontaktierungsmaterial 25 ebenfalls mit dem Träger 35 haftverbunden ist.

Zwischen dem Vorfixiermittel 30 und dem Träger 35 wirkt eine derartige Adhäsionskraft, dass die Substratanordnung 10 einfach zu transportieren ist, wobei sich das Substrat 20 nicht vom Träger 35 während des Transportes ablösen kann. Die Adhäsionskraft zwischen dem Vorfixiermittel 30 und dem Träger 35 ist allerdings derart gering, dass das Substrat 20 zusammen mit dem Vorfixiermittel 30 und dem Kontaktierungsmaterial 25 vom Träger 35 abgelöst werden kann, sofern ein Bauteil mit der Substratanordnung 10 verbunden werden soll. Auf dem Träger 35 sind sowohl der Substratabschnitt 21 als auch der Substratabschnitt 21' angeordnet. Mit anderen Worten können auf einem Träger 35 mehrere Substratabschnitte 21, 21' mit entsprechenden Vorfixiermitteln 30 und Kontaktierungsmaterialien 25 angeordnet sein.

In Fig. 6 wird eine Substratanordnung 10 dargestellt, die mit Hilfe einer Düse 40 vom Träger 35 gelöst wird. Das Ablösen des Substrates 20 zusammen mit dem Vorfixiermittel 30 und dem Kontaktierungsmaterial 25 vom Träger 35 kann beispielsweise im Rahmen eines Pick and Place-Prozesses mit Hilfe der Düse 40 durchgeführt werden.

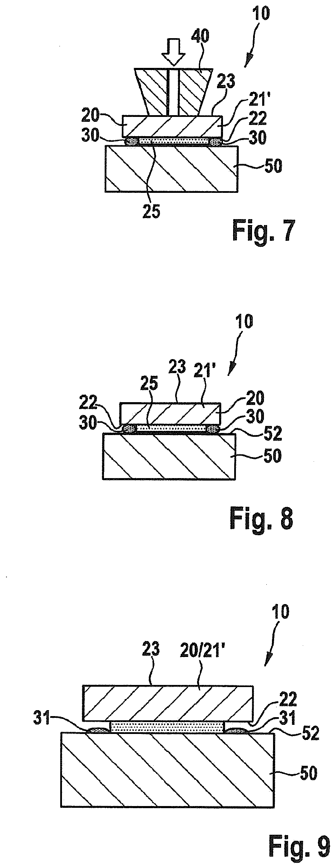

Die Figuren 7 bis 9 zeigen ein Verfahren zum Verbinden eines Elektronikbauteils 50 mit einer Substratanordnung 10 gemäß einer ersten Ausführungsform der Erfindung. In diesem Fall wird die Substratanordnung 10 mit Hilfe der Düse 40 zunächst von einem Träger 35 entfernt. Die Substratanordnung 10 wird mit Hilfe der Düse 40 derart auf dem Elektronikbauteil 50 positioniert, dass die erste Seite 22 des Substrates 20 dem Elektronikbauteil 50 zugewandt angeordnet ist. Die Düse 40 wirkt auf die zweite Seite 23 des Substrates 20. Wie in Fig. 7 dargestellt ist, wird die Substratanordnung 10 auf das Elektronikbauteil 50 aufgesetzt, wobei lediglich das Vorfixiermittel 30 das Bauteil 50 berührt bzw. lediglich das Vorfixiermittel 30 mit dem Bauteil 50 verbunden ist. Bei dem dargestellten Bauteil 50 kann es sich beispielsweise um einen Silizium-Halbleiter handeln. Zwischen dem Kontaktierungsmaterial 25 und dem Bauteil 50 ist ein Abstand ausgebildet, wobei dieser Abstand aufgrund der unterschiedlichen Dicken des Vorfixiermittels und des Kontaktierungsmittels gebildet wird.

In Fig. 8 ist bereits die Düse 40 von der Substratanordnung 10 entfernt. Es erfolgt eine Wärmebeaufschlagung bei einer Temperatur von 100 bis 150 °C. Dadurch wird das Vorfixiermittel 30 aktiviert, sodass ein Vorfixieren der Substratanordnung 10 mit dem Elektronikbauteil 50 erfolgt. Vorzugsweise handelt es sich bei der Vorfixierung um eine Klebeverbindung zwischen dem Substrat 20, insbesondere der ersten Seite 22 des Substrates 20, und dem Elektronikbauteil 50, insbesondere der, dem Substrat 20 zugewandten Seite 52 des Elektronikbauteils 50, wobei die Klebeverbindung aufgrund des Vorfixiermittels 30 hergestellt ist.

An dieser Stelle wird darauf hingewiesen, dass das Vortrocknen bzw. der Trocknungsschritt, wie dieser in Fig. 4 dargestellt ist, optional ist. Es ist möglich, dass das Vorfixiermittel 30 auf die erste Seite 22 des Substrates 20 aufgebracht wird, wobei daran anschließend sofort eine Vorfixierung eines Elektronikbauteils 50, 51 mit der Substratanordnung 10 erfolgt. Das Ausbilden eines Trägers 35 ist in diesem Fall nicht notwendig. Das Vorfixiermittel 30 wird in diesem Fall unmittelbar vor der Bestückung mit einem Elektronikbauteil 50, 51 bzw. unmittelbar vor dem Bestücken auf ein Elektronikbauteil 50, 51 auf das Substrat 20 aufgetragen.

Nach dem Vorfixieren, wie dies in Fig. 8 dargestellt wird, erfolgt das eigentliche Verbinden der Substratanordnung 10 mit dem Elektronikbauteil 50. Als Verbinden ist das Zusammenfügen der Substratanordnung 10 mit dem Elektronikbauteil 51 zu verstehen. Das Verbinden kann durch Löten oder Verpressen oder Versintern erfolgen. Hier ist es denkbar, dass in einem Prozessofen, z. B. in einem Drucksinterofen oder Reflowofen oder Laminierofen, die Substratanordnung 10 mit dem Elektronikbauteil 50 versintert wird. Während des Drucksinterns verflüchtigen sich die organischen/polymeren Bestandteile des Vorfixiermittels 30 weitestgehend. Mit anderen Worten wird das Vorfixiermittel 30 während des Verbindens oder nach dem Verbinden zumindest teilweise entfernt, insbesondere abgebrannt und/oder abgeschmolzen. Die organischen/polymeren Bestandteile des Vorfixiermittels 30 werden aufgrund thermischer Zersetzung und/oder aufgrund des auftretenden Verdampfens entfernt. Die Klebeverbindung zwischen dem Substrat 20 und dem Bauteil 50 ist folglich nach dem Versintern und/oder Verpressen und/oder Verlöten nicht mehr ausgebildet.

Auf dem Elektronikbauteil 50 und/oder auf dem Substrat 20, insbesondere auf der ersten Seite 22 des Substrates 20 sind größtenteils oder vorzugsweise ausschließlich nur noch Reste 31, insbesondere die anorganischen Füllstoffe, des ursprünglichen Vorfixiermittels 30 ausgebildet. Im dargestellten Beispiel sind auf der ersten Seite 52 des Elektronikbauteils 50 Reste 31 des Vorfixiermittels 30 ausgebildet.

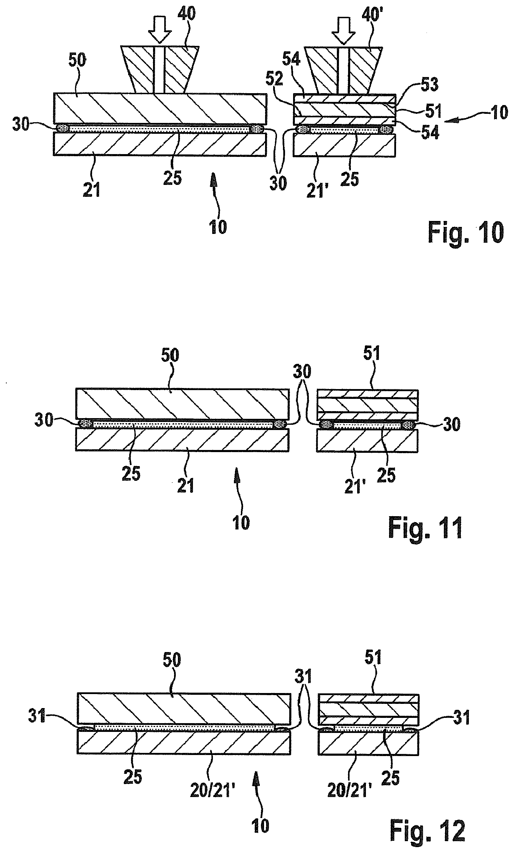

In den Figuren 10 bis 12 wird ein Verfahren zum Verbinden von Elektronikbauteilen 50 und 51 mit einer Substratanordnung 10 gemäß einem weiteren Ausführungsbeispiel dargestellt.

In Fig. 10 ist dargestellt, dass eine Substratanordnung 10, die zwei Substratabschnitte 21 und 21' umfasst mit einem ersten Elektronikbauteil 50 und einem zweiten Elektronikbauteil 51 bestückt wird. Sowohl der Substratabschnitt 21 als auch der Substratabschnitt 21' umfasst ein Kontaktierungsmaterial 25 und seitlich des jeweiligen Kontaktierungsmaterials 25 ausgebildete Vorfixiermittel 30.

Sowohl das erste Elektronikbauteil 50 als auch das zweite Elektronikbauteil 51 werden mit Hilfe von Düsen 40 und 40' derart zu der Substratanordnung 10 positioniert, dass die erste Seite 22 des Substrates 20 dem ersten Elektronikbauteil 50 und dem zweiten Elektronikbauteil 51 zugewandt angeordnet ist. Bei dem ersten Elektronikbauteil 50 kann es sich um einen Silizium-Halbleiter handeln. Das zweite Elektronikbauteil 51 weist sowohl auf der ersten Seite 52 als auch auf der zweiten Seite 53 eine Beschichtung 54 auf.

Wie in Fig. 11 dargestellt ist, erfolgt ein Vorfixieren der Substratanordnung 10 mit dem ersten Elektronikbauteil 50 und dem zweiten Elektronikbauteil 51 durch das auf der ersten Seite 22 des Substrates 20 abschnittsweise aufgebrachte Vorfixiermittel 30. Hinsichtlich des Vorfixiermittels 30 gelten die bereits im Zusammenhang mit den Figuren 1 bis 9 aufgeführten Erläuterungen. Zum Vorfixieren mittels des Vorfixiermittels 30 wird die Substratanordnung 10 zusammen mit dem ersten Elektronikbauteil 50 und dem zweiten Elektronikbauteil 52 einer Wärmebeaufschlagung, insbesondere bei Temperaturen von 100 bis 150 °C, ausgesetzt. Es entsteht eine Klebeverbindung zwischen dem ersten Elektronikbauteil 50 und dem Substrat 20, insbesondere zwischen dem ersten Elektronikbauteil 50 und der ersten Seite 22 des Substrates 20. Außerdem entsteht eine Klebeverbindung zwischen dem zweiten Elektronikbauteil 51 und dem Substrat 20, insbesondere der ersten Seite 22 des Substrates 20.

Nach dem Vorfixieren erfolgt das Verbinden der Substratanordnung 10 mit dem ersten Elektronikbauteil 50 und dem zweiten Elektronikbauteil 51. Beim Verbinden, vorzugsweise Versintern, wird das Vorfixiermittel 30 zumindest abschnittsweise entfernt, insbesondere abgebrannt und/oder abgeschmolzen.

Wie in Fig. 12 dargestellt ist, verbleibt auf der ersten Seite 22 des Substrates 20 lediglich ein Rest 31 des Vorfixiermittels 30. Vorzugsweise handelt es sich bei diesem verbleibenden Rest 31 des Vorfixiermittels 30 um die anorganischen Füllstoffe des ursprünglichen Vorfixiermittels 30.

Das Elektronikbauteil 50 sowie das zweite Elektronikbauteil 51 ist in Fig. 12 vollständig mit der Substratanordnung 10 verbunden. Die Substratanordnung 10 weist ein Substrat 20 mit einer ersten Seite 22 und einer zweiten Seite 23 auf. Auf der ersten Seite 22 des Substrates 20 befindet sich der Rest 31 eines ursprünglichen Vorfixiermittels 30.

An dieser Stelle sei darauf hingewiesen, dass alle oben im Zusammenhang mit den Ausführungsformen gemäß Figuren 1 bis 12 beschriebenen Verfahrensschritte und Elemente für sich allein gesehen oder in jeder Kombination, insbesondere die in den Zeichnungen dargestellten Details, als erfindungswesentlich beansprucht werden. Auch eine wahlweise Kombination der Verfahrensschritte nach einem der Ansprüche 1 bis 8 mit einem Verfahrensschritt nach einem der Ansprüche 21 bis 31 ist möglich.

Ergänzend wird auf folgende Ausführungsbeispiele der Erfindung verwiesen:
1. Ausführungsbeispiel: Verfahren zum Herstellen einer Substratanordnung (10) zur Verbindung mit einem Elektronikbauteil (50; 51), umfassend die Schritte:
   - Bereitstellen eines Substrates (20), insbesondere eines DCB-Substrats oder eines PCB-Substrats oder eines Leadframes, mit einer ersten Seite (22) und einer zweiten Seite (23),
   - abschnittsweises Aufbringen eines Vorfixiermittels (30) auf die erste Seite (22) des Substrates (20).
2. Ausführungsbeispiel: Verfahren nach Ausführungsbeispiel 1,
   **gekennzeichnet durch**
   abschnittsweises Aufbringen eines Kontaktierungsmaterials (25) auf die erste Seite (22) des Substrates (20), insbesondere vor dem Aufbringen des Vorfixiermittels (30).
3. Ausführungsbeispiel: Verfahren nach Ausführungsbeispiel 1 oder 2,
   **dadurch gekennzeichnet, dass**
   das Vorfixiermittel (30) ein Lot und/oder ein Klebemittel, insbesondere ein Klebemittel das 20 - 45 Gew.-% thermoplastisches Polymer und 40 - 70 Gew.-% organisches Lösemittel und 10 - 25 Gew.-% anorganische Füllstoffpartikel und 0 - 0,5 Gew.-% weitere Additive aufweist, ist.
4. Ausführungsbeispiel: Verfahren nach einem der vorangegangenen Ausführungsbeispiele, insbesondere nach einem der Ausführungsbeispiele 2 bis 3, **gekennzeichnet durch**
   Positionieren des Substrates (20) mit aufgebrachtem Vorfixiermittel (30), insbesondere mit aufgebrachtem Vorfixiermittel (30) und aufgebrachtem Kontaktierungsmaterial (25), auf einem Träger (35) derart, dass die erste Seite (22) des Substrates (20) dem Träger (35) zugewandt angeordnet ist, wobei das Vorfixiermittel (30) und/oder das Kontaktierungsmaterial (25) mit dem Träger (35) zumindest haftverbunden wird/werden.
5. Ausführungsbeispiel: Verfahren nach einem der vorangegangenen Ausführungsbeispiele, insbesondere nach einem der Ausführungsbeispiele 2 bis 4, **dadurch gekennzeichnet,** dass
   das Vorfixiermittel (30) zumindest abschnittsweise seitlich des Kontaktierungsmaterials (25) auf die erste Seite (22) des Substrates (20) aufgebracht wird.
6. Ausführungsbeispiel: Verfahren nach einem der vorangegangenen Ausführungsbeispiele, insbesondere nach einem der Ausführungsbeispiele 2 bis 5, **dadurch gekennzeichnet, dass**
   das Vorfixiermittel (30) derart auf die erste Seite (22) des Substrates (20) aufgebracht wird, dass das Vorfixiermittel (30) dicker als das Kontaktierungsmaterial (25) ist.
7. Ausführungsbeispiel: Substratanordnung (10) zur Verbindung mit einem Elektronikbauteil (50; 51), umfassend ein Substrat (20) mit einer ersten Seite (22) und einer zweiten Seite (23), wobei auf der ersten Seite (22) des Substrates (20) abschnittsweise ein Vorfixiermittel (30) aufgebracht ist.
8. Ausführungsbeispiel: Substratanordnung (10) nach Ausführungsbeispiel 7, **dadurch gekennzeichnet,** dass
   das Vorfixiermittel (30) ein Lot und/oder ein Klebemittel, insbesondere ein Klebemittel das 20 - 45 Gew.-% thermoplastisches Polymer und 40 - 70 Gew.-% organisches Lösemittel und 10 - 25 Gew.-% anorganische Füllstoffpartikel und 0 - 0,5 Gew.-% weitere Additive aufweist, ist.
9. Ausführungsbeispiel: Substratanordnung (10) nach Ausführungsbeispiel 7 oder 8,
   **dadurch gekennzeichnet,** dass
   auf der ersten Seite (22) des Substrates (20) abschnittsweise ein Kontaktierungsmaterial (25) aufgebracht ist.
10. Ausführungsbeispiel: Substratanordnung (10) nach Ausführungsbeispiel 9, **dadurch gekennzeichnet, dass**
   das Vorfixiermittel (30) zumindest abschnittsweise seitlich des Kontaktierungsmaterials (25) auf der ersten Seite (22) des Substrates (20) aufgebracht ist.
11. Ausführungsbeispiel: Substratanordnung (10) nach einem der Ausführungsbeispiele 9 bis 10,
   **dadurch gekennzeichnet,** dass
   das Vorfixiermittel (30) dicker als das Kontaktierungsmaterial (25) ist.
12. Ausführungsbeispiel: Verfahren zum Verbinden eines Elektronikbauteils (50; 51) mit einer Substratanordnung (10; 10'), insbesondere mit einer Substratanordnung (10; 10') nach einem der Ausführungsbeispiele 7 bis 11 und/oder mit einer Substratanordnung (10; 10'), die nach einem Verfahren nach einem der Ausführungsbeispiele 1 bis 6 hergestellt ist, umfassend die Schritte:
   - Positionieren der Substratanordnung (10; 10') und des Elektronikbauteils (50; 51) zueinander derart, dass eine/die erste Seite (22) des Substrates (20) dem Elektronikbauteil (50; 51) zugewandt angeordnet ist,
   - Vorfixieren der Substratanordnung (10; 10') mit dem Elektronikbauteil (50; 51) durch ein/das auf der ersten Seite (22) des Substrates (20) abschnittsweise aufgebrachte(s) Vorfixiermittel (30),
   - Verbinden der Substratanordnung (10) mit dem Elektronikbauteil (50; 51).
13. Ausführungsbeispiel: Verfahren nach Ausführungsbeispiel 12,
   **dadurch gekennzeichnet, dass**
   beim Vorfixieren der Substratanordnung (10; 10') mit dem Elektronikbauteil (50; 51) eine Wärmebeaufschlagung erfolgt.
14. Ausführungsbeispiel: Verfahren nach einem der Ausführungsbeispiele 12 bis 13,
   **dadurch gekennzeichnet, dass**
   die Substratanordnung (10; 10') beim Verbinden mit dem Elektronikbauteil (50; 51) mit diesem versintert oder verpresst oder verlötet wird.
15. Ausführungsbeispiel: Verfahren nach einem der Ausführungsbeispiele 12 bis 14, insbesondere nach Ausführungsbeispiel 14,
   **dadurch gekennzeichnet, dass**
   das Vorfixiermittel (30) während des Verbindens oder nach dem Verbinden, insbesondere während des Versinterns und/oder des Verlötens und/oder des Verpressens, der Substratanordnung (10; 10') mit dem Elektronikbauteil (50; 51), zumindest teilweise entfernt, insbesondere abgebrannt und/oder abgeschmolzen, wird.
16. Ausführungsbeispiel: Verfahren zum Verbinden eines Elektronikbauteils (50; 51) mit einem Substrat (20), insbesondere mit einem DCB-Substrat oder einem PCB-Substrat oder einem Leadframe, wobei das Substrat (20) eine erste Seite (22) und eine zweite Seite (23) aufweist,
   umfassend die Schritte:
   - Bereitstellen eines Elektronikbauteils (50; 51) mit einer ersten Seite (52) und einer zweiten Seite (53),
   - abschnittsweises Aufbringen eines Vorfixiermittels (30) auf die erste Seite (52) des Elektronikbauteils (50; 51) und/oder auf die erste Seite (22) des Substrats (20).
17. Ausführungsbeispiel: Verfahren nach Ausführungsbeispiel 16,
   **gekennzeichnet durch**
   abschnittsweises Aufbringen eines Kontaktierungsmaterials (25) auf die erste Seite (52) des Elektronikbauteils (50; 51) und/oder auf die erste Seite (22) des Substrats (20), insbesondere vor dem Aufbringen des Vorfixiermittels (30).
18. Ausführungsbeispiel: Verfahren nach Ausführungsbeispiel 16 oder 17,
   **dadurch gekennzeichnet, dass**
   das Vorfixiermittel (30) ein Lot und/oder ein Klebemittel, insbesondere ein Klebemittel das 20 - 45 Gew.-% thermoplastisches Polymer und 40 - 70 Gew.-% organisches Lösemittel und 10 - 25 Gew.-% anorganische Füllstoffpartikel und 0 - 0,5 Gew.-% weitere Additive aufweist, ist.
19. Ausführungsbeispiel: Elektronikbauteil (50; 51), das mit einer Substratanordnung (10; 10') verbunden ist, insbesondere in einem Verfahren nach einem der Ausführungsbeispiele 12 bis 15 verbunden ist, oder das mit einem Substrat (20) verbunden ist, insbesondere in einem Verfahren nach einem der Ausführungsbeispiele 16 bis 18 verbunden ist, wobei ein/das Substrat (20), insbesondere das Substrat (20) der Substratanordnung (10; 10'), eine erste Seite (22) und eine zweite Seite (23) umfasst, wobei auf der ersten Seite (22) des Substrates (20) und/oder auf der dem Substrat (20) zugewandten ersten Seite (52) des Elektronikbauteils (50; 51) abschnittsweise ein Rest (31) eines Vorfixiermittels (30) ausgebildet ist und die Substratanordnung (10; 10') oder das Substrat (20) mit dem Elektronikbauteil (50; 51) derart verbunden ist, dass die erste Seite (22) des Substrates (20) dem Elektronikbauteil (50; 51) zugewandt angeordnet ist.

### Bezugszeichenliste

- 10, 10': Substratanordnung
- 20: Substrat
- 21, 21': Substratabschnitt
- 22: erste Seite Substrat
- 23: zweite Seite Substrat
- 25: Kontaktierungsmaterial
- 26: Seitenkante
- 30: Vorfixiermittel
- 35: Träger
- 40, 40': Düse
- 50: Elektronikbauteil
- 51: Elektronikbauteil
- 52: erste Seite Elektronikbauteil
- 53: zweite Seite Elektronikbauteil
- 54: Beschichtung

- d_{VF1}: Dicke Vorfixiermittel vor Trocknung
- d_{VF2}: Dicke Vorfixiermittel nach Trocknung
- d_{KM}: Dicke Kontaktierungsmaterial

## Patentansprüche

1. Verfahren zum Herstellen einer Substratanordnung (10) zur Verbindung mit einem Elektronikbauteil (50; 51), umfassend die Schritte:
- Bereitstellen eines Substrates (20), insbesondere eines DCB-Substrats oder eines PCB-Substrats oder eines Leadframes, mit einer ersten Seite (22) und einer zweiten Seite (23),
- abschnittsweises Aufbringen eines Vorfixiermittels (30) auf die erste Seite (22) des Substrates (20),
**dadurch gekennzeichnet, dass**
das Vorfixiermittel (30) ein Klebemittel ist, das 20 - 45 Gew.-% thermoplastisches Polymer und 40 - 70 Gew.-% organisches Lösemittel und 10 - 25 Gew.-% anorganische Füllstoffpartikel und 0 - 0,5 Gew.-% weitere Additive aufweist.

2. Verfahren nach Anspruch 1,
**dadurch gekennzeichnet, dass**
das thermoplastische Polymer ein (Meth)acrylcopolymer ist.

3. Verfahren nach Anspruch 1 oder 2,
**dadurch gekennzeichnet, dass**
die organischen Lösemittel 30 bis 100 Gew.-% Terpineole aufweisen.

4. Verfahren nach einem der Ansprüche 1 bis 3,
**gekennzeichnet durch**
abschnittsweises Aufbringen eines Kontaktierungsmaterials (25) auf die erste Seite (22) des Substrates (20) vor dem Aufbringen des Vorfixiermittels (30).

5. Verfahren nach Anspruch 4,
**dadurch gekennzeichnet, dass**
das Vorfixiermittel (30) zumindest abschnittsweise seitlich des Kontaktierungsmaterials (25) auf die erste Seite (22) des Substrates (20) aufgebracht wird.

6. Verfahren nach Anspruch 4 oder 5,
**dadurch gekennzeichnet, dass**
das Vorfixiermittel (30) derart auf die erste Seite (22) des Substrates (20) aufgebracht wird, dass das Vorfixiermittel (30) dicker als das Kontaktierungsmaterial (25) ist.

7. Substratanordnung (10) zur Verbindung mit einem Elektronikbauteil (50; 51), umfassend ein Substrat (20) mit einer ersten Seite (22) und einer zweiten Seite (23), wobei auf der ersten Seite (22) des Substrates (20) abschnittsweise ein Vorfixiermittel (30) aufgebracht ist,
**dadurch gekennzeichnet, dass**
das Vorfixiermittel (30) ein Klebemittel ist, das 20 - 45 Gew.-% thermoplastisches Polymer und 40 - 70 Gew.-% organisches Lösemittel und 10 - 25 Gew.-% anorganische Füllstoffpartikel und 0 - 0,5 Gew.-% weitere Additive aufweist.

8. Substratanordnung (10) nach Anspruch 7,
**dadurch gekennzeichnet, dass**
das thermoplastische Polymer ein (Meth)acrylcopolymer ist.

9. Substratanordnung (10) nach Anspruch 7 oder 8,
**dadurch gekennzeichnet, dass**
die organischen Lösemittel 30 bis 100 Gew.-% Terpineole aufweisen.

10. Substratanordnung (10) nach einem der Ansprüche 7 bis 9,
**dadurch gekennzeichnet, dass**
auf der ersten Seite (22) des Substrates (20) abschnittsweise ein Kontaktierungsmaterial (25) aufgebracht ist, wobei
das Vorfixiermittel (30) zumindest abschnittsweise seitlich des Kontaktierungsmaterials (25) auf der ersten Seite (22) des Substrates (20) aufgebracht ist, wobei
das Vorfixiermittel (30) vorzugsweise dicker als das Kontaktierungsmaterial (25) ist.

11. Verfahren zum Verbinden eines Elektronikbauteils (50; 51) mit einer Substratanordnung (10; 10') nach einem der Ansprüche 7 bis 10 und/oder mit einer Substratanordnung (10; 10'), die nach einem Verfahren nach einem der Ansprüche 1 bis 6 hergestellt ist, umfassend die Schritte:
- Positionieren der Substratanordnung (10; 10') und des Elektronikbauteils (50; 51) zueinander derart, dass eine/die erste Seite (22) des Substrates (20) dem Elektronikbauteil (50; 51) zugewandt angeordnet ist,
- Vorfixieren der Substratanordnung (10; 10') mit dem Elektronikbauteil (50; 51) durch ein/das auf der ersten Seite (22) des Substrates (20) abschnittsweise aufgebrachte(s) Vorfixiermittel (30), wobei das Vorfixiermittel (30) ein Klebemittel ist, das 20 - 45 Gew.-% thermoplastisches Polymer und 40 - 70 Gew.-% organisches Lösemittel und 10 - 25 Gew.-% anorganische Füllstoffpartikel und 0 - 0,5 Gew.-% weitere Additive aufweist,
- Verbinden der Substratanordnung (10) mit dem Elektronikbauteil (50; 51).

12. Verfahren nach Anspruch 11,
**dadurch gekennzeichnet, dass**
das Vorfixiermittel (30) während des Verbindens oder nach dem Verbinden, insbesondere während des Versinterns und/oder des Verlötens und/oder des Verpressens, der Substratanordnung (10; 10') mit dem Elektronikbauteil (50; 51), zumindest teilweise entfernt, insbesondere abgebrannt und/oder abgeschmolzen, wird.

13. Verfahren zum Verbinden eines Elektronikbauteils (50; 51) mit einem Substrat (20), insbesondere mit einem DCB-Substrat oder einem PCB-Substrat oder einem Leadframe, wobei das Substrat (20) eine erste Seite (22) und eine zweite Seite (23) aufweist,
umfassend die Schritte:
- Bereitstellen eines Elektronikbauteils (50; 51) mit einer ersten Seite (52) und einer zweiten Seite (53),
- abschnittsweises Aufbringen eines Vorfixiermittels (30) auf die erste Seite (52) des Elektronikbauteils (50; 51) und/oder auf die erste Seite (22) des Substrats (20), wobei das Vorfixiermittel (30) ein Klebemittel ist, das 20 - 45 Gew.-% thermoplastisches Polymer und 40 - 70 Gew.-% organisches Lösemittel und 10 - 25 Gew.-% anorganische Füllstoffpartikel und 0 - 0,5 Gew.-% weitere Additive aufweist, ist.

14. Verfahren nach Anspruch 13,
**gekennzeichnet durch**
abschnittsweises Aufbringen eines Kontaktierungsmaterials (25) auf die erste Seite (52) des Elektronikbauteils (50; 51) und/oder auf die erste Seite (22) des Substrats (20), insbesondere vor dem Aufbringen des Vorfixiermittels (30).

15. Elektronikbauteil (50; 51), das mit einer Substratanordnung (10; 10') in einem Verfahren nach einem der Ansprüche 11 bis 12 verbunden ist, oder das mit einem Substrat (20) nach einem der Ansprüche 13 bis 14 verbunden ist, wobei das Substrat (20), insbesondere das Substrat (20) der Substratanordnung (10; 10'), eine erste Seite (22) und eine zweite Seite (23) umfasst, wobei auf der ersten Seite (22) des Substrates (20) und/oder auf der dem Substrat (20) zugewandten ersten Seite (52) des Elektronikbauteils (50; 51) abschnittsweise ein Rest (31) eines Vorfixiermittels (30) ausgebildet ist und die Substratanordnung (10; 10') oder das Substrat (20) mit dem Elektronikbauteil (50; 51) derart verbunden ist, dass die erste Seite (22) des Substrates (20) dem Elektronikbauteil (50; 51) zugewandt angeordnet ist.
